# EUROPÄISCHE PATENTSCHRIFT

(11) **EP 1 256 267 B1**
(45) Veröffentlichungstag und Bekanntmachung des Hinweises auf die Patenterteilung: **16.06.2004**
(21) Anmeldenummer: 01903666.4
(22) Anmeldetag: 22.01.2001
(51) Int. Cl.: H05K 9/00

(54) **VERFAHREN ZUR HERSTELLUNG EINER ELEKTROMAGNETISCHEN ABSCHIRMUNG**
METHOD FOR PRODUCING AN ELECTROMAGNETIC SHIELD
PROCEDE DE FABRICATION D'UN BLINDAGE ELECTROMAGNETIQUE

(30) Priorität: 22.01.2000 DE 10003355
(43) Veröffentlichungstag der Anmeldung: 13.11.2002
(73) Patentinhaber: Kahl, Helmut, 12307 Berlin (DE); Tiburtius, Bernd, 14532 Kleinmachnow (DE)
(72) Erfinder: Kahl, Helmut, 12307 Berlin (DE); Tiburtius, Bernd, 14532 Kleinmachnow (DE)
(74) Vertreter: Keussen, Christof, Dr.
(86) Internationale Anmeldenummer: PCT/EP2001/000671
(87) Internationale Veröffentlichungsnummer: WO 2001/054466

(56) Entgegenhaltungen:
- EP-A- 0 721 294
- WO-A-98/08365
- DE-A- 4 319 965
- US-A- 4 838 475
- PATENT ABSTRACTS OF JAPAN vol. 012, no. 395 (E-671), 20. Oktober 1988 (1988-10-20) & JP 63 136639 A (FUJI XEROX CO LTD), 8. Juni 1988 (1988-06-08)
- PATENT ABSTRACTS OF JAPAN vol. 1995, no. 01, 28. Februar 1995 (1995-02-28) & JP 06 283884 A (NIPPON CHEMICON CORP), 7. Oktober 1994 (1994-10-07)

## Beschreibung

Die Erfindung betrifft ein Verfahren zur Herstellung einer mechanischen, sowie elektrisch leitfähigen Verbindung zwischen einer Leiterplatte oder einem Gehäuseteil und einer elektrisch leitfähigen Abdeckung (Metallkappe) zur elektromagnetischen Abschirmung.

Es ist bekannt, zur elektromagnetischen Abschirmung von Bauteilen bzw. von Baugruppen, z. B. Leiterplatten oder Gehäusen von Mobiltelefonen (oder der Telekommunikation oder Sende- und/oder Empfangstechnik) Metallkappen einzusetzen, die wenigstens eine partielle Abschirmung gewährleisten.

Solche - relativ starre - Metallkappen werden zur mechanischen Befestigung auf eine Leiterplatte maschinell aufgelötet und bieten, wenn die Lötung einwandfrei durchgeführt ist, auch eine gute Abschirmfunktion. Die beim Löten aufzubringende hohe Wärmezufuhr führt immer wieder zu Schwierigkeiten bei der Serienfertigung für die elektrischen Bauteile bzw. deren Abschirmung mittels der vorgenannten Metallkappentechnik.

Aufgabe der Erfindung ist es, die vorgenannten Schwierigkeiten zu beseitigen und die bisherige Fertigungstechnologie zu verbessern.

Die Erfindung schlägt vor, auf die Leiterplatte (oberseitig) oder die eletrisch leitfähige Abdeckung, z. B. Metallkappe (unterseitig) eine elektrisch leitfähige, im Ausgangzustand flüssige oder pastöse Masse aufzubringen. Diese Masse kann sowohl aus Silikon, Expoxid, PU, Teflon, Acryl, EPDM, EPM oder anderen Bindestoffen bestehen, als auch einen elektrisch leitfähigen Füllstoff enthalten. Dieser Füllstoff kann sowohl Kohlenstoff, Metall, Aluminium, Kupfer, Silber, Gold z. B. als Faserkugeln oder Streifen enthalten. Aber auch multifunktionelle Füllstoffe, wie z. B. versilbertes Glas, Kupfer, Nickel, Aluminium, vernickelter Graphit oder ähnliches ist als elektrisch leitender Füllstoff geeignet.

Die elektrische leitfähige Masse, die den elektrisch leitfähigen Füllstoff enthält, kann durch einen Dispensvorgang, wie z. B. im Patent P 43 19 965.8-09 beschrieben ist, auf die Leiterplatte oder ein Gehäuseunterteil oder auch auf die elektrisch leitfähige Abdeckung aufgetragen werden. Es ist aber auch möglich, die elektrisch leitfähige Masse durch ein Druckverfahren, z. B. Schablonendruck oder Siebdruck oder Tauchverfahren (Dippen) oder Ausformung usw. aufzutragen.

Soweit in der vorliegenden Anmeldung von einer Metallkappe die Rede ist, umfasst dies auch eine Kappe aus Kunststoff oder aus einem anderen nicht leitenden Material, welches mit einer leitfähigen Schicht, z. B. einer Metallisierung, versehen ist oder eine elektrisch leitfähige Schicht innenseitig im Material aufweist.

Eine elektrisch leitfähige Masse, wie beispielsweise mit Silber versetztes Silikon, hat die Eigenschaft, selbstklebend und auch selbsthaftend zu sein, so dass beim Zusammenfügen der Leiterplatte und der elektrische leitfähigen Abdeckung (Abschirmkappe, Metallkappe) eine dauerhafte - wenn aber gewünscht, auch lösbare - Verbindung zwischen diesen beiden Teilen hergestellt werden kann. Diese Verbindung kann durch einen Aushärtungsprozess, Trocknungsprozess, Vernetzungsprozess, z. B. durch Wärmestrahlung (oder sonstige Energieeinstrahlung), Alphastrahlung, Betastrahlung, Gammastrahlung, Licht, UV-Strahlung, IR-Strahlung bzw. in einer besonderen Luftfeuchtigkeitsumgebung etc. noch verstärkt, eingeleitet oder abgeschlossen werden. Hierbei sind insbesondere solche Bedingungen für die Vernetzung bzw. Trocknung bzw. Aushärtung der eletrisch leitfähigen Masse vorteilhaft, die bei deutlich niedrigeren Temperaturen, als z. B. beim Löten durchführbar sind.

Mit der Erfindung wird erreicht, dass z. B. das Bestücken der Leiterplatten mittels Metallkappen automatisch an einem SMD- (Surface Mounting Device) Bestückungsplatz durchgeführt werden kann. So wird ein Verrücken der Abschirmkappe verhindert, ohne dass eine starke Wärmezufuhr wie im Lötprozess auftritt. Damit wird die Abschirmkappe nicht nur elektrisch an die Leiterplatte angeschlossen, sondern auch mechanisch an ihrer vorbestimmten Position befestigt, arretiert bzw. gehalten.

Die Erfindung ist nachfolgend anhand eines in der Zeichnung dargestellten Ausführungsbeispiel näher erläutert. Es zeigen:
- Fig. 1: einen Querschnitt einer Seitenwand einer Abschirmkappe, unterhalb derer eine Raupe einer elektrisch leitfähigen Masse angeordnet ist,
- Fig. 2: einen Querschnitt einer Leiterplatte mit elektrischen Bauteilen und aufgesetzter Kappe,
- Fig. 3: eine Seitenansicht der Seitenwand der aufgesetzten Abschirmkappe,
- Fig. 4: einen Querschnitt durch die Darstellung nach Fig. 3 gemäß A bis A,
- Fig. 5: einen Querschnitt einer weiteren erfindungsgemäßen Lösung.

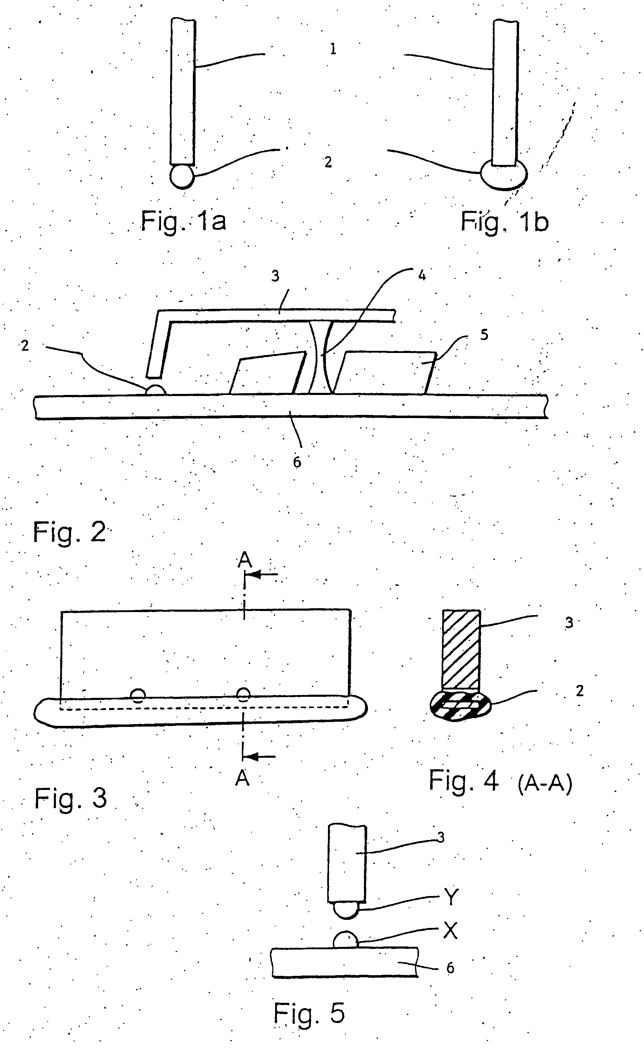

In Fig. 1a ist eine einraupige, elektrisch leitfähige Masse 2 an der Unterseite der Seitenwand 1 einer Metallkappe 3 (Abschirmkappe) angebracht (dispensiert oder gedippt oder warmgeformt oder kaltangeformt). Gemäß Fig. 1b umgibt die elektrisch leitfähige Masse 2 den unteren Randbereich der Seitenwand 1 der auf einer Leiterptatte oder einem Gehäuse ausgesetzten Metallkappe.

Fig. 2 zeigt eine Leiterptatte 6 mit elektrischen Bauteilen 5, die abzuschirmen sind, sowie eine auf der Leiterplatte 6 aufgebrachte Dichtung 2, auf welche die Abschirmkappe 3 nach Fig. 1 aufgesetzt wird. Hierbei ist die elektrisch leitfähige Masse - die Dichtung 2 - als eine Raupe auf der Oberseite der Leiterplatte 6 aufgetragen. Die Eigenschaften der Dichtung 2 hinsichtlich Leitfähigkeit, Elastizität, Thixotropie, Härte, Lösbarkeit usw. sind individuell einstellbar oder können auch so sein, wie sie in DE P 43 19 965.8-09 beschrieben sind.

Soweit in den Figuren eine einzige Raupe der elektrisch leitfähigen Massen dargestellt ist, kann es sich hierbei auch um mehrfach übereinander und/oder nebeneinander liegende Raupen/Schichten handeln, welche in einem (Dispens-) Vorgang (oder mehreren Dispensvorgängen und/oder ein oder mehrfaches Eintauchen (Dippen) oder Anformschritte) auf die jeweilige Fläche aufgetragen werden. Auch ist es z. B. möglich, auf die Oberseite der Leiterplätte sowie auf die entsprechende Unterseite der Seitenwand der Abschirmkappe wenigstens eine Raupe (Schicht) aus elektrisch leitfähiger Masse aufzutragen und dann beide Teile durch Übereinanderlagerung beider Raupen (Schichten) zu verbinden.

Dabei ist es besonders vorteilhaft - siehe Fig. 5 - wenn die auf der Leiterplatte 6 aufgebrachte Schicht (Raupe) als Reagenz einer ersten Komponente X und die auf der Unterseite der Seitenwand der Abschirmkappe 3 aufgebrachte Schicht (Raupe) einer auf die Reagenz reagierende zweite Komponente Y einer Zweikomponentenverbindung X-Y dienen. Beide Komponenten X und Y bestehen aus anderen Stoffen und reagieren nur, wenn sie zusammengebracht werden, beispielsweise durch Übereinanderlagerung. Hierbei verbinden sich beide Schichten (Raupen) wie ein Zwei- (oder Drei- oder Mehr-) Komponentenkleber, so dass neben der elektrischen Verbindung auch eine sehr gute mechanische Verbindung von Kappe und Leiterplatte (Gehäuseunterboden) gegeben ist, die auch hohen Zugkräften standhält.

Durch die vorgeschriebene Ausführung einer Zweikomponentendichtung ist die Fertigung der gesamten Dichtung einfach, weil der Dichtungsaustrag zeitunabhängig und unkritisch vorgenommen werden kann. So kann beispielweise die auf der Leiterplatte aufgebrachte Schicht zunächst aufgebracht werden, ohne dass sofort ein Aufsetzen der Metallkappe mit der zweiten Komponente erfolgen muss. Es ist durchaus möglich, dass der zeitliche Versatz des Aufbringens der einzelnen Schichten (Raupen) und das Zusammenfügen vön Leiterptatte und Abschirmkappe mehrere Sekunden bis zu mehreren Stunden (oder mehrere Tage oder Wochen) unterschiedlich sein kann, je nachdem, wie die Materialien der Komponenten X und Y ausgeführt sind. Bei der X-Komponente muss es sich im Übrigen auch nicht um eine elektrisch leitfähige Masse handeln, sondern die Schicht mit der X- (Y) Komponente kann sehr dünn ausgeführt sein und kann sich beim Zusammentreffen mit der Y- (X) Komponente mehr oder weniger auflösen, so dass dann die Raupe aus der Y- (X-) Komponente die Metallkappe und die darunter liegende Leiterplatte (oder das darunter liegende Gehäuse) mechanisch fixiert und durchkontaktiert.

Die vorgeschriebene Ausführung hat den Vorteil, dass die Schicht mit der X-Komponente bereits bei Fertigung der Leiterplatte auf den durchzukontaktierenden Stellen aufgetragen werden kann. Sollte es für die Verbindung der beiden Schichten aus der X-Y-Komponente notwendig sein, dass hierbei eine gewisse Atmosphäre (z. B. feuchte oder lösemittelgefüllte Atmosphäre) vorhanden sein muss, kann hierfür bei dem Aufbringen der Metallkappe auf der Leiterplatte gesorgt werden.

Fig. 3 zeigt in einer Seitenansicht die Seitenwand der Abschirmkappe nach Fig. 1 und unterhalb dieser Seitenwand die Dichtung, hergestellt aus der elektrisch leitfähigen Masse.

Fig. 4 zeigt eine Querschnitt durch die Darstellung nach Fig. 3. Hierbei ist zu erkennen, dass der untere Rand der Metallkappe 3 vollständig in dem Dichtungsmaterial 2 eingetaucht ist und sogar die Öffnung nach Fig. 3 der Seitenwand zum Teil mit Dichtungsmaterial gefüllt ist.

Aufgrund der selbsthaftenden bzw. selbstklebenden Eigenschaften der leitfähigen Dichtungsmasse ist nicht nur eine elektrisch leitende Verbindung zwischen der Abschirmkappe und der Leiterplatte (Gehäuseteil) hergestellt, sondem auch eine mechanisch ausreichend feste Verbindung beider Teile, wobei aufgrund der Elastizität der leitfähigen Masse auch noch eine gewisse Elastizität der Kappe gegeben ist.

Es versteht sich von selbst, dass die dargestellte Verbindung der Abschimkappe und der Leiterplatte auch dadurch hergestellt werden kann, dass die elektrisch leitfähige Masse nicht nur dispensiert, sondern in einem anderen Auftragsverfahren, z. B. Schablonendruck, aufgebracht wird.

Es ist auch möglich, auf die Oberseite der Kappe noch eine weitere Schicht der elektrisch leitfähigen Masse (eine Raupe oder mehrere Raupen) aufzubringen, was besonders dann vorteilhaft sein kann, wenn größere Toleranzen zugelassen werden sollen und die Abschirmkappe oberseitig von einem Gehäuse oder einem anderen elektrisch leitfähigen Bauteil abgedeckt wird.

Bei den Geräten, die mit der vorbeschriebenen Abschirmung versehen werden, kann es sich insbesondere um solche handeln, die eine Sendeeinrichtung und/oder Empfangseinrichtung aufweisen, beispielsweise ein Mobiltelefon oder auch eine Basisstation eines Telekommunikationsnetzes.

Es ist auch möglich, dass zwischen der Abschirmkappe und der abzuschirmenden Unterlage, z. B. der Leiterplatte 6, ein Strang (oder mehrere Stränge) eines Schrumpfungsmaterials 4 (z. B. Schrumpfgummi, an Klappe 3 und Leiterplatte 6 angeklebt) angeordnet ist (oder sind). Dies ist als Beispiel in Fig. 2 Mitte gezeigt. Wenn dieses Material einem Schrumpfungsprozess ausgesetzt ist, zieht es sich zusammen und bindet hierbei automatisch, weil das Material sowohl an der Innenseite der Kappe als auch an der Leiterplatte fest angeklebt ist, beide Teile mehr als bisher zusammen. In Fig. 2 ist der Strang (konkave Querschnittsform) des Schrumpfungsmaterials in einem Beispiel dargestellt.

## Patentansprüche

1. Verfahren zur Herstellung einer Verbindung zwischen einer Leiterplatte (6) und einer elektrisch leitfähigen Kappe (3) zur elektromagnetischen Abschirmung,
wobei zwischen der Leiterplatte (6) und der Kappe (3) eine elektrisch leitfähige, im Ausgangszustand verarbeitungsfähige Masse (2) angeordnet wird und mittels der elektrisch leitfähigen Masse (2) die Kappe (3) auf der Leiterplatte (6) mechanisch fixiert und gleichzeitig eine elektrische Kontaktierung zwischen der Kappe (3) zur Leiterplatte (6) hergestellt wird,
wobei die elektrische leitfähige Masse (2) aus zwei unterschiedlichen Komponenten (X, Y) besteht und vor der Zusammenfügung der Kappe (3) und der Leiterplatte (6) sowohl die Kappe (3) als auch die Leiterplatte (6) an den zugewandten Stellen mit einer entsprechenden Materialschicht (2) einer der beiden Komponenten versehen werden, so dass die Kappe (3) als auch die Leiterplatte (6) mit unterschiedlichen Materialschichten versehen sind und die beiden Schichten sich beim Zusammenfügen der Kappe (3) mit der Leiterplatte verbinden und miteinander wie ein Zwei-Komponentenkleber reagieren.

2. Verfahren nach Anspruch 1,
**dadurch gekennzeichnet, dass** das Verfahren zur automatischen Bestückung der Leiterplatte (6) mit der Kappe (3) durchgeführt wird.

3. Verfahren nach Anspruch 1 oder 2,
**dadurch gekennzeichnet, dass** das Verfahren zur automatischen Bestückung der Leiterplatte (6) mit einer Kappe (3) an einem SMD Bestückungsplatz ausgeführt wird.

4. Verfahren nach einem der vorhergehenden Ansprüche,
**dadurch gekennzeichnet, dass** die leitfähige Masse (2) ein Silikon, Epoxid, PU, Teflon, Acryl, EPDM, EPM oder anderen Bindestoffen bzw. eine Mischung hiervon enthält und einen elektrischen leitfähigen Füllstoff aufweist.

5. Verfahren nach Anspruch 4,
**dadurch gekennzeichnet, dass** der Füllstoff aus Kohlenstoff, Metall, Faserkugeln aus Metall, beispielsweise Aluminium, Kupfer, Silber, Gold oder multifunktionelle Füllstoffe, wie etwa versilbertes Glas, Kupfer, Nickel, Aluminium oder vernickelter Graphit, besteht.

6. Verfahren nach einem der vorhergehenden Ansprüche,
**dadurch gekennzeichnet, dass** die Kappe (3) zum Abschirmen eine Metallkappe bzw. metallisierte Kappe oder Deckel aus nicht leitendem Material ist.

7. Verfahren nach einem der vorhergehenden Ansprüche,
**dadurch gekennzeichnet, dass** die elektrisch leitfähige Masse (2) auf die entsprechenden Stellen der Leiterplatte (6) aufgetragen wird, so dass dann die Abschirmkappe (3) auf die Stellen, an denen die elektrisch leitfähige Masse (2) auf die Leiterplatte (6) aufgetragen ist, aufgesetzt wird.

8. Verfahren nach einem der Ansprüche 1 bis 7,
**dadurch gekennzeichnet, dass** der Auftrag der elektrisch leitfähigen Masse (2) auf die Leiterplatte (6) oder aber auch Kappe (3) durch ein Auftragsverfahren, wie ein Dispensverfahren, Druckverfahren, Schablonendruck, Siebdruck, Tauchen, Dippen, Tampondruckverfahren erfolgt.

9. Verfahren nach einem der vorhergehenden Ansprüche,
**dadurch gekennzeichnet, dass** nach dem Aufbau der Verbindung zwischen der Leiterplatte (6) und der Kappe (3) mit der elektrisch leitfähigen Masse (2) eine dauerhafte Verbindung dieser Teile hergestellt wird, wobei die Masse sich verfestigt und/oder vernetzt und/oder trocknet.

10. Verfahren nach Anspruch 9,
**dadurch gekennzeichnet, dass** die dauerhafte Verbindung durch einen Aushärtungsprozess erfolgt, wobei hierzu eine Behandlung mittels Wärme und/oder Alfa-Strahlen und/oder Beta-Strahlen und/oder Gamma-Strahlen und/oder Luftfeuchtigkeit und/oder Licht und/oder ultraviolettes Licht und/oder Infrarot-Strahlung erfolgt.

11. Verfähren nach einem der vorhergehenden Ansprüche,
**dadurch gekennzeichnet, dass** die Temperatur beim Aushärtungsprozess niedriger ist, als die Temperaturen, welche beim Löten zur Verbindung der Kappe (3) mit der Leiterplatte (6) auftreten.

12. Verfahren nach einem der vorhergehenden Ansprüche,
**dadurch gekennzeichnet, dass** zur Fixierung und elektrischen Kontaktierung zwisehen der Kappe (3) und der Leiterplatte (6) sowohl auf die Leiterplatte (6) eine Schicht mit einer Komponente X sowie auf die Unterseite einer Seitenwand einer Kappe (3) eine Schicht mit einer Komponente Y aufgetragen wird, wobei beide Komponenten dergestalt sind, dass sie miteinander chemisch und/oder physikalisch reagieren, so dass die gewünschte mechanische Fixierung und elektrische Kontaktierung der Kappe (3) auf der Leiterplatte (6) gewährleistet ist.

13. Verfahren nach einem der vorhergehenden Ansprüche,
dadurch gekennzeichhet, dass zwischen der Abschirmkappe (3) und der abschirmenden Unterlage ein schrumpfungsfähiges. Material (4) angeordnet ist, welches bei Schrumpfung die Abschirmkappe und die Unterlage unterhalb der Abschirmkappe zusammenzieht bzw. fixiert.

14. Verbindung einer elektrischen leitfähigen Kappe (3) mit einer Leiterplatte (6) mittels eines Verfahrens nach einem der vorhergehenden Ansprüche.

15. Leiterplatte (6), auf der eine elektrisch leitfähige Kappe (3) angeordnet ist, welche die Funktion eines Abschirmelements von auf der Leiterplatte (6) angeordneten Bauteilen (5) hat, wobei zur mechanischen Positionierung der Kappe (3) zwischen der Leiterplatte (6) und der Kappe (3) eine elektrisch leitfähige Masse (2) ausgebildet ist, welche eine elektrisch leitende Verbindung zwischen der Leiterplatte (6) und der Metallkappe (3) herstellt,
wobei die elektrische leitfähige Masse (2) aus zwei unterschiedlichen Komponenten (X, Y) besteht und vor der Zusammenfügung der Kappe (3) und der Leiterplatte (6) sowohl die Kappe (3) als auch die Leiterplatte (6) an den zugewandten Stellen mit einer entsprechenden Materialschicht (2) einer der beiden Komponenten versehen werden, so dass die Kappe (3) als auch die Leiterplatte (6) mit unterschiedlichen Materiälschichten versehen sind und die beiden Schichten sich beim Zusammenfügen der Kappe (3) mit der Leiterplatte verbinden und miteinander wie ein Zwei-Komponentenkleber reagieren.

16. Leiterplatte (6) nach Anspruch 15,
**dadurch gekennzeichnet, dass** die Kappe (3) in einem vorbestimmten Abstand zur
Leiterplatte (6) angeordnet ist und der beabstandete Raum zwischen Kappe (3) und Leiterplatte (6) von der elektrisch leitfähigen Masse (2) ausgefüllt ist.

17. Elektrisches Gerät mit einer leiterplatte nach Anspruch 15 oder 16.

18. Elektrisches Gerät nach Anspruch 17,
**dadurch gekennzeichnet, dass** das elektrische Gerät wenigstens eine Sendeeinrichtung und/oder Empfangseinrichtung aufweist.

19. Gerät nach Anspruch 18,
**dadurch gekennzeichnet, dass** das elektrische Gerät ein Möbilfunkgerät ist.

## Claims

1. Method for producing a connection between a printed circuit board (6) and an electrically conductive cap (3) for electromagnetic shielding, wherein an electrically conductive composition (2) which is capable of being processed in the initial state is arranged between the printed circuit board (6) and the cap (3) and, by means of the electrically conductive composition (2) the cap (3) is mechanically fixed on the printed circuit board (6) and at the same time electrical contacting is established between the cap (3) and the printed circuit board (6), wherein the electrically conductive composition (2) comprises two different components (X, Y) and, before the cap (3) and the printed circuit board (6) are joined together, both the cap (3) and the printed circuit board (6) are provided at the mutually facing locations with a corresponding material layer (2) of one of the two components, so that the cap (3) and the printed circuit board (6) are provided with different material layers and, when the cap (3) is joined together with the printed circuit board, the two layers are connected and react with each other like a two-pack adhesive.

2. Method according to Claim 1, **characterized in that** the method is carried out for the automatic fitting of the printed circuit board (6) with the cap (3).

3. Method according to Claim 1 or 2, **characterized in that** the method for automatically fitting the printed circuit board (6) with a cap (3) is performed at an SMD fitting station.

4. Method according to one of the preceding claims, **characterized in that** the conductive composition (2) contains a silicone, epoxy, PU, Teflon, acryl, EPDM, EPM or other binders or a mixture thereof and has an electrically conductive filler.

5. Method according to Claim 4, **characterized in that** the filler comprises carbon, metal, fibre balls of metal, for example aluminium, copper, silver, gold or multifunctional fillers, such as for instance silver-plated glass, copper, nickel, aluminium or nickel-plated graphite.

6. Method according to one of the preceding claims, **characterized in that** the cap (3) for shielding is a metal cap or metallized cap or a cover of non-conducting material.

7. Method according to one of the preceding claims, **characterized in that** the electrically conductive composition (2) is applied to the appropriate locations of the printed circuit board (6), so that the shielding cap (3) is then mounted onto the locations at which the electrically conductive composition (2) has been applied to the printed circuit board (6).

8. Method according to one of Claims 1 to 7, **characterized in that** the application of the electrically conductive composition (2) to the printed circuit board (6) or else to the cap (3) is performed by an application process, such as a dispensing process, printing process, stencil printing, screen printing, immersion, dipping, or a pad printing process.

9. Method according to one of the preceding claims, **characterized in that**, after the connection between the printed circuit board (6) and the cap (3) has been made with the electrically conductive composition (2), a durable connection of these parts is established, with the composition being solidified and/or crosslinked and/or dried.

10. Method according to Claim 9, **characterized in that** the durable connection takes place by a curing process, for which purpose treatment is performed by means of heat and/or alpha rays and/or beta rays and/or gamma rays and/or air humidity and/or light and/or ultraviolet light and/or infrared radiation.

11. Method according to one of the preceding claims, **characterized in that** the temperature in the curing process is lower than the temperatures which occur during the soldering for the connection of the cap (3) to the printed circuit board (6).

12. Method according to one of the preceding claims, **characterized in that**, for the fixing and electrical contacting between the cap (3) and the printed circuit board (6), a layer with a component X is applied to the printed circuit board (6) and a layer with a component Y is applied to the underside of a side wall of a cap (3), the two components being such that they chemically and/or physically react with each other, so that the desired mechanical fixing and electrical contacting of the cap (3) on the printed circuit board (6) is ensured.

13. Method according to one of the preceding claims, **characterized in that** arranged between the shielding cap (3) and the shielding substrate is a shrinkable material (4), which upon shrinkage pulls together or fixes the shielding cap and the substrate underneath the shielding cap.

14. Connection of an electrically conductive cap (3) to a printed circuit board (6) by means of a method according to one of the preceding claims.

15. Printed circuit board (6), on which there is arranged an electrically conductive cap (3), which has the function of a shielding element for components (5) arranged on the printed circuit board (6), wherein, for the mechanical positioning of the cap (3), an electrically conductive composition (2) is formed between the printed circuit board (6) and the cap (3) and establishes an electrically conducting connection between the printed circuit board (6) and the metal cap (3),
wherein the electrically conductive composition (2) comprises two different components (X, Y) and, before the cap (3) and the printed circuit board (6) are joined together, both the cap (3) and the printed circuit board (6) are provided at the mutually facing locations with a corresponding material layer (2) of one of the two components, so that the cap (3) and the printed circuit board (6) are provided with different material layers and, when the cap (3) is joined together with the printed circuit board, the two layers are connected and react with each other like a two-pack adhesive.

16. Printed circuit board (6) according to Claim 15, **characterized in that** the cap (3) is arranged at a predetermined distance from the printed circuit board (6) and the space provided in this way between the cap (3) and the printed circuit board (6) is filled by the electrically conductive composition (2).

17. Electrical device with a printed circuit board according to Claims 15 or 16.

18. Electrical device according to Claim 17, **characterized in that** the electrical device has at least one transmitting device and/or receiving device.

19. Device according to Claim 18, **characterized in that** the electrical device is a mobile radio telephone.

## Revendications

1. Procédé de réalisation d'une liaison entre une plaquette de circuits imprimés (6) et un capot (3) électriquement conducteur pour le blindage électromagnétique, une masse (2) électriquement conductrice, susceptible d'être traitée à l'état initial, étant disposée entre la plaquette de circuits imprimés (6) et le capot (3) et, au moyen de la masse (2) électriquement conductrice, le capot (3) étant fixé mécaniquement sur la plaquette de circuits imprimés (6) et en même temps un contact électrique étant réalisé entre le capot (3) et la plaquette de circuits imprimés (6), la masse (2) électriquement conductrice étant constituée de deux composants (X, Y) différents et, avant assemblage du capot (3) et de la plaquette de circuits imprimés (6), le capot (3) comme la plaquette de circuits imprimés (6) étant pourvus, sur les emplacements tournés les uns vers les autres, d'une couche de matière (2) correspondante de l'un des deux composants, ce qui fait que le capot (3) comme la plaquette de circuits imprimés (6) sont pourvus de couches de matières différentes et les deux couches se lient à l'assemblage du capot (3) et de la plaquette de circuits imprimés, et réagissent entre elles comme une colle à deux composants.

2. Procédé selon la revendication 1, **caractérisé en ce que** le procédé est mis en oeuvre pour équiper automatiquement la plaquette de circuits imprimés (6) avec le capot (3).

3. Procédé selon la revendication 1 ou 2, **caractérisé en ce que** le procédé d'équipement automatique de la plaquette de circuits imprimés (6) avec un capot (3) est réalisé dans un poste d'équipement (SMT).

4. Procédé selon l'une des revendications précédentes, **caractérisé en ce que** la masse conductrice (2) contient un silicone, une résine époxy, un PU, du téflon, une résine acrylique, un EPDM, un EPM ou d'autres liants ou un mélange de ceux-ci, et comporte une charge électriquement conductrice.

5. Procédé selon la revendication 4, **caractérisé en ce que** la charge est constituée de carbone, de métal, de billes de fibres en métal, par exemple d'aluminium, de cuivre, d'argent, d'or ou de charges multifonctionnelles, telles que par exemple du verre argenté, du cuivre, du nickel, de l'aluminium ou du graphite nickelé.

6. Procédé selon l'une des revendications précédentes, **caractérisé en ce que** le capot (3) de blindage est un capot métallique ou capot métallisé ou un couvercle en matériau non conducteur.

7. Procédé selon l'une des revendications précédentes, **caractérisé en ce que** la masse (2) électriquement conductrice est appliquée aux emplacements correspondants de la plaquette de circuits imprimés (6) de manière qu'alors le capot de blindage 3 soit placé aux emplacements auxquels la masse (2) électriquement conductrice est appliquée sur la plaquette de circuits imprimés (6).

8. Procédé selon l'une des revendications 1 à 7, **caractérisé en ce que** l'application de la masse (2) électriquement conductrice sur la plaquette de circuits imprimés (6) ou encore sur le capot (3) s'effectue par un procédé d'application tel qu'un procédé de dispersion, procédé d'impression, impression au pochoir, sérigraphie, immersion, sauçage, procédé d'impression au tampon.

9. Procédé selon l'une des revendications précédentes, **caractérisé en ce qu'**après constitution de la liaison entre la plaquette de circuits imprimés (6) et le capot (3) avec la masse (2) électriquement conductrice, on réalise une liaison durable de ces pièces, la masse se solidifiant et/ ou se mouillant et/ ou séchant.

10. Procédé selon la revendication 9, **caractérisé en ce que** la liaison durable s'effectue par un processus de durcissement, le traitement s'effectuant à cet effet au moyen de chaleur et/ou de rayons alpha et/ou de rayons bêta, et/ou de rayons gamma et/ou de l'humidité de l'air et/ou de lumière et/ou de lumière ultraviolette et/ou de rayonnements infrarouges.

11. Procédé selon l'une des revendications précédentes, **caractérisé en ce que** pendant le processus de durcissement, la température est inférieure aux températures qui se manifestent pendant le soudage pour la liaison du capot (3) avec la plaquette de circuits imprimés (6).

12. Procédé selon l'une des revendications précédentes, **caractérisé en ce que** pour la fixation et la mise en contact électrique entre le capot (3) et la plaquette de circuits imprimés (6), on applique sur la plaquette de circuits imprimés (6) une couche d'un composant (X) ainsi que sur la face inférieure d'une paroi latérale d'un capot (3), une couche d'un composant (Y), les deux composants étant tels qu'ils réagissent entre eux chimiquement et/ou physiquement, ce qui fait que la fixation mécanique et la mise en contact électrique du capot (3) sur la plaquette de circuits imprimés (6) sont garanties.

13. Procédé selon l'une des revendications précédentes, **caractérisé en ce qu'**entre le capot de blindage (3) et le support à blinder, est disposé un matériau (4) rétractable qui au retrait tire ou fixe le capot de blindage et le support sous le capot de blindage.

14. Liaison entre un capot (3) électriquement conducteur et une plaquette de circuits imprimés (6) au moyen d'un procédé selon l'une des revendications précédentes.

15. Plaquette de circuits imprimés (6) sur laquelle est disposé un capot (3) électriquement conducteur qui a la fonction d'un élément de blindage de composants (5) disposés sur la plaquette de circuits imprimés (6), une masse (2) électriquement conductrice, qui réalise une liaison électriquement conductrice entre la plaquette de circuits à imprimés (6) et le capot métallique (3), étant réalisée, pour le positionnement mécanique du capot (3) entre la plaquette de circuits imprimés (6) et le capot (3), la masse (2) électriquement conductrice étant constituée de deux composants (X, Y) différents et, avant assemblage du capot (3) et de la plaquette de circuits imprimés (6), le capot (3) comme la plaquette de circuits imprimés (6) étant pourvus, sur les emplacements tournés les uns vers les autres, d'une couche de matière (2) correspondante de l'un des deux composants, ce qui fait que le capot (3) comme la plaquette de circuits imprimés (6) sont pourvus de couches de matières différentes et les deux couches se lient à l'assemblage du capot (3) et de la plaquette de circuits imprimés, et réagissent entre elles comme une colle à deux composants.

16. Plaquette de circuits imprimés (6) selon la revendication 15, **caractérisée en ce que** le capot (3) est disposé à une distance prédéterminée de la plaquette de circuits imprimés (6) et l'espace formé entre le capot (3) et la plaquette de circuits imprimés (6) est rempli par la masse (2) électriquement conductrice.

17. Appareil électrique avec une plaquette de circuits imprimés selon la revendication 15 ou 16.

18. Appareil électrique selon la revendication 17, **caractérisé en ce que** l'appareil électrique comporte au moins un dispositif d'émission et/ou dispositif de réception.

19. Appareil selon la revendication 18, **caractérisé en ce que** l'appareil électrique est un appareil radio mobile.
